# EUROPEAN PATENT SPECIFICATION

(11) **EP 3 636 594 B1**
(45) Date of publication and mention of the grant of the patent: **14.06.2023**
(21) Application number: 18812687.4
(22) Date of filing: 22.05.2018
(51) Int. Cl.: C01B 33/035, B08B 9/093, C23C 16/24, C23C 16/44, H01L 21/67

(54) **CLEANING DEVICE**
REINIGUNGSVORRICHTUNG
DISPOSITIF DE NETTOYAGE

(30) Priority: 08.06.2017 JP 2017113665
(43) Date of publication of application: 15.04.2020
(73) Proprietor: Tokuyama Corporation, Shunan-shi, Yamaguchi 745-8648 (JP)
(72) Inventor: TAKATOU, Sou, Shunan-shi Yamaguchi 745-8648 (JP); FUKUE, Makoto, Shunan-shi Yamaguchi 745-8648 (JP); MITO, Yoshifumi, Shunan-shi Yamaguchi 745-8648 (JP)
(74) Representative: Bittner, Thomas L.
(86) International application number: PCT/JP2018/019642
(87) International publication number: WO 2018/225497

(56) References cited:
- WO-A1-2012/063432
- GB-A- 2 169 687
- JP-A- 2000 297 342
- JP-A- 2007 332 462
- JP-A- 2010 275 183
- JP-A- 2013 199 694
- JP-A- 2017 039 617
- US-A- 5 108 512
- DATABASE WPI Week 201240 Thomson Scientific, London, GB; AN 2012-F80999 XP002802005, -& WO 2012/063432 A1 (SHINETSU CHEM CO LTD) 18 May 2012 (2012-05-18)
- DATABASE WPI Week 201718 Thomson Scientific, London, GB; AN 2017-14178U XP002802007, -& JP 2017 039617 A (MITSUBISHI MATERIALS CORP) 23 February 2017 (2017-02-23)

## Description

The present invention relates to a cleaning device for a reactor and a method of cleaning a reactor. More specifically, the present invention relates to a cleaning device and a cleaning method for cleaning an inner wall surface of a reactor for use in vapor phase epitaxy of polycrystalline silicon by the Siemens method.

### Background Art

The Siemens method is known as a method of producing high-purity polycrystalline silicon which is used as a semiconductor material. The Siemens method is a production method in which polycrystalline silicon is deposited. In the production method, a mixed gas of chlorosilane and hydrogen is used as a material gas. The mixed gas comes into contact with a silicon seed rod which has been heated. Then, thermal decomposition and hydrogen reduction occur at the surface of the silicon seed rod, so that the polycrystalline silicon is deposited. As a device for carrying out the production method, a reactor (bell jar) for polysilicon production is used. This reactor has a reactor furnace in which a lot of silicon seed rods are provided upright.

In a case where polycrystalline silicon is produced in the bell jar, a by-product attaches to an inner wall surface of the bell jar which is cooled. The by-product having attached to the inner wall surface of the bell jar is hydrolyzed with water in the atmosphere and forms hydrogen chloride. The hydrogen chloride thus formed causes corrosion of the inner wall surface of the reactor furnace. Further, in a state in which the by-product is attached to the inner wall surface of the bell jar, the inner wall surface of the bell jar has a decreased reflectance. When the inner wall surface of the bell jar has a decreased reflectance, power efficiency deteriorates and the temperature inside the bell jar does not increase sufficiently in production of polycrystalline silicon. As a result, polycrystalline silicon cannot be deposited.

On this account, in order to efficiently produce high-purity polycrystalline silicon, it is necessary to clean the inner wall surface of the bell jar after the end of a reaction and before the start of a next reaction which follows the first reaction. Conventionally, various techniques have been proposed as methods of cleaning an inner wall surface of a bell jar.

For example, Patent JP 56-114815 (1981) discloses a technique of removing a substance attached to an inner wall surface of a reactor furnace. According to the technique, (i) the inner wall surface of the reactor furnace is heated by supplying steam into a furnace wall of the reactor furnace and then (ii) a humidity-adjusted gas is introduced into the reactor furnace, so that the substance attached to the inner wall surface of the reactor furnace is hydrolyzed. Further, into the reactor furnace, a nozzle is inserted and a high-speed jet of an inert gas is emitted toward the inner wall surface. As a result, the substance attached to the inner wall surface of the reactor furnace is removed. Patent JP 6-216036 (1994) discloses a technique of removing a silicon substance attached on an inner wall surface of a reactor furnace, by causing carbon dioxide pellets to collide with the silicon substance. Patent JP 2009-196882 discloses a technique of cleaning an inner wall surface of a reactor furnace. According to this technique, while a shaft provided at a central part is being rotated and caused to move in a vertical direction, a three-dimensional high-pressure jet of cleaning water, which is pure water or ultrapure water, is emitted through a nozzle at an upper end of the shaft. As a result, the inner wall surface of the reactor furnace is cleaned. Patent JP 2012-101984 discloses a technique of removing a substance attached on an inner wall surface of a reactor furnace, by blowing ice particles to the substance with use of high-pressure gas. Patent JP 2012-20917 discloses a technique of cleaning an inner wall surface of a reactor furnace. According to this technique, the inner wall surface is cleaned with a three-dimensional high-pressure jet of cleaning water provided through a rotating nozzle, which revolves around a vertical shaft that is movable along a vertical direction. In this technique, the cleaning water is pure water or ultrapure water. Patent JP 2-145767 (1990) discloses a technique of cleaning an inner wall of a main body of a reactor furnace by a rotating brush, which emits a jet of liquid while rotating.

However, the above-described conventional techniques have the following problems. First, the substance attached to the reactor furnace is often firmly attached to the inner wall surface. Accordingly, with regard to the technique disclosed in Patent JP 56-114815 (1981) according to which a high-speed jet of an inert gas is emitted and the techniques disclosed in Patent JP 2009-196882 and JP 2012-20917 according to which an attached substance is removed by a high-pressure jet of pure water or ultrapure water, these techniques of Patent JP 56-114815 (1981), JP 2009-196882 and JP 2012-20917 may be insufficient in physical-removal ability. Further, the technique disclosed in Patent JP 6-216036 (1994) with use of carbon dioxide pellets and the technique disclosed in Patent JP 2012-101984 with use of ice particles do not cause hydrolysis of an attached substance to proceed. On this account, the attached substance may stay behind. In such a case, hydrogen chloride may be formed with water in the atmosphere when the reactor furnace is opened. On the other hand, in the technique disclosed in Patent JP 2-145767 (1990) with use of a rotating brush, it is difficult to put a brush thoroughly all over an uneven inner wall surface of the reactor furnace. Accordingly, the technique disclosed in Patent JP 2-145767 (1990) may not be capable of completely removing an attached substance.

A method for cleaning an inner surface of a bell jar used for manufacturing polycrystalline silicon is known in WO 2012/063432 A1 as well as the document DATABASE WPI Week 201240, Thomson Scientific, London, GB, AN 2012-F80999. Fine ice granules are collided with the inner surface of the bell jar from tip of nozzles, and deposits at the inner surface of the bell jar are removed.

Document GB 2 169 687 A refers to an erosion resistant article formed by cladding a substrate with tiles having at least a surface layer of polycrystalline material such as diamond and / or cubic boron nitrade. The tiles may be entirely polycrystalline diamond or may have a backing of cemented tungsten carbide. Such an article can be trim for a high pressure valve or choke wherein a sleeve is partly lined with polycrystalline diamond tiles and a plug is clad with polycrystalline diamond tiles. Alternatively, such an article is a nozzle for sandblasting or drilling mud. The substrate may comprise cemented tungsten carbide or other carbides.

The documents JP 2017 039617 A and DATABASE WPI Week 201718, Thomson Scientific, London, GB, AN 2017-14178U relate to a reaction furnace cleaning device comprising a horizontally installed receiving stand having an almost disk-shaped receiving pan and further having a flange part in which the outer circumferential part of the receiving pan is mounted with a lower edge opening marginal part of a bell jar; a nozzle apparatus high pressure-jetting cleaning water to an inner wall face of the bell jar; and a holding part capable of being mounted with the lower edge opening marginal part of the bell jar and having mounting parts plurally provided at intervals in the circumferential direction. The holding part holds the mounting parts movably between an upper position of the flange part and a more outward position than the flange part.

Document US 5,108,512 A refers to a process for the cleaning of the inner surface of a chemical vapor deposition reactor used in the production of polycrystalline silicon. The process comprises impacting the surfaces to be cleaned with solid carbon dioxide pellets. The carbon dioxide pellets dislodge silicon deposits from the surface of the reactor without damaging the surface of the reactor and without providing a source for contamination of polycrystalline silicon produced in the cleaned reactor.

### Summary

In view of the above problems, an embodiment of the present invention has been attained. An object of the present invention is to provide a cleaning device etc. capable of reliably removing a substance attached to an inner wall surface of a bell jar.

A device according to claim 1 is provided. The problem is solved by the device of claim 1.

In an example for better understanding the invention, a method of cleaning an inner wall surface of a bell jar for use in production of polycrystalline silicon may be provided, by causing nozzles to discharge a cleaning liquid at the inner wall surface, the cleaning liquid containing abrasive particles, the method including the steps of: (a) causing the nozzles to discharge the cleaning liquid at a discharge pressure at which erosion of the nozzles, due to the cleaning liquid, occurs by not more than 500 µm / hour; and (b) adjusting a distance between the inner wall surface and the nozzles so that an impingement pressure, at which the cleaning liquid impinges on the inner wall surface, secures a pressure at which dirt on the inner wall surface can be removed.

In another example, a device for cleaning an inner wall surface of a bell jar for use in production of polycrystalline silicon may be provided, by causing nozzles to discharge a cleaning liquid at the inner wall surface, the cleaning liquid containing abrasive particles, the nozzles including first nozzles and second nozzles, the device comprising: a first cleaning unit including the first nozzles of the device, which are arranged along at least half an arc of an upper-part curved inner wall surface of the bell jar, the arc passing an apex of the upper-part curved inner wall surface; a second cleaning unit including the second nozzles of the device, which are arranged along a shape in a height direction of a cylindrical-body lateral inner wall surface of the bell jar; and a driving mechanism configured to cause the first cleaning unit and the second cleaning unit to move relative to the bell jar, in a state where the nozzles of the device are in both of (i) a first state in which the first nozzles of the first cleaning unit are put close to the upper-part curved inner wall surface and (ii) a second state in which the second nozzles of the second cleaning unit are put close to the cylindrical-body lateral inner wall surface.

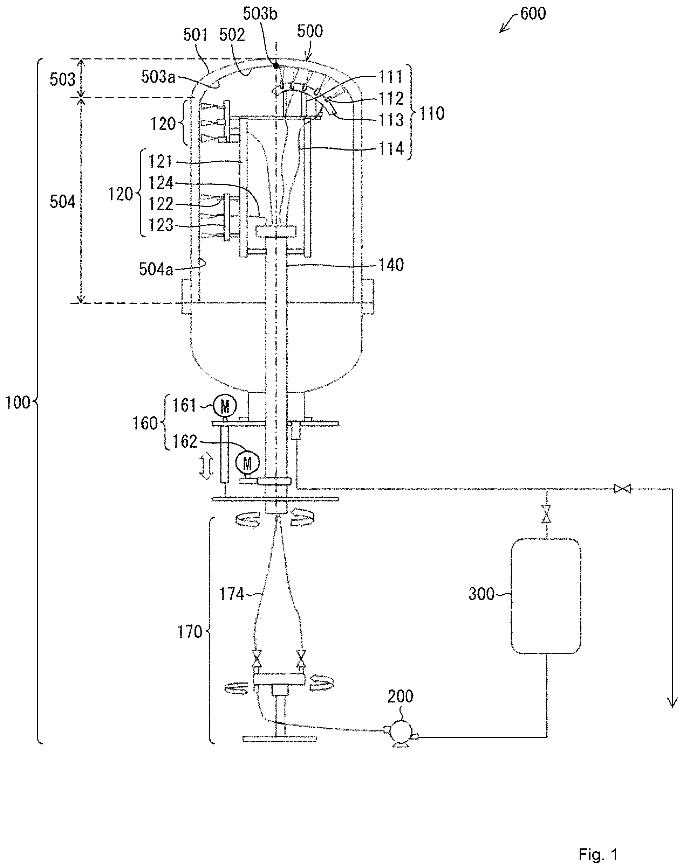

One example advantageously makes it possible to remove a substance attached to an inner wall surface of a bell jar. For example, the inner wall surface of the bell jar could be cleaned to the extent that the inner wall surface had a reflectance of not less than 0.7, in a case where cleaning was carried out by using a cleaning device illustrated in Fig. 1 in accordance with Example 1 under the following conditions (a) to (c): (a) a cleaning liquid for use in this cleaning contained highly abrasive particles; (b) a distance between each nozzle and the wall surface of the bell jar was adjusted (to approximately 200 mm) so that (i) erosion of the nozzle occurred by 100 µm / hour and (ii) an impingement pressure, at which the cleaning liquid impinges on the wall surface, was 15 MPa; and (c) a cleaning time was 2 hours. Further, even in a case where the above cleaning was carried out 30 times, no defect was found in the nozzle, and the inner wall surface of the bel jar could be cleaned to a substantially unchanged extent.

In contrast, an inner wall surface of a bell jar could not be cleaned to the extent that the inner wall surface had a reflectance of not less than 0.7, in a case where cleaning was carried out, with use of the same cleaning liquid as in the above example, by using a device in accordance with one of the above-described conventional techniques. This device cleans an inner surface of a reactor furnace by a three-dimensional high-pressure jet of cleaning water emitted through a nozzle at an upper end of a shaft which is provided at a central part, while the shaft is being rotated and caused to move in a vertical direction. In this case, cleaning was carried out such that an impingement pressure, at which the cleaning liquid impinges on the inner wall surface, was 15 MPa. As a result, the nozzle was damaged due to erosion 1.7 hours after the cleaning had been started.

### Brief Description of Drawings

- Fig. 1: is a view schematically illustrating an arrangement of a cleaning device in accordance with Example 1.
- Fig. 2: is a view schematically illustrating an arrangement of a supply unit of the cleaning device.
- (a) and (b) of Fig. 3: are each a flow chart depicting a method of cleaning by the cleaning device
- Fig. 4: is a view schematically illustrating an arrangement of a portion of a cleaning device in accordance with Example 2.

The following description will discuss further examples to better understand the invention. The present invention is, however, not limited to the examples below in details. Note that, for convenience of explanation, members having an identical function(s) in the following examples are given an identical reference sign, and a repeated description of those members is omitted as appropriate.

### Example 1

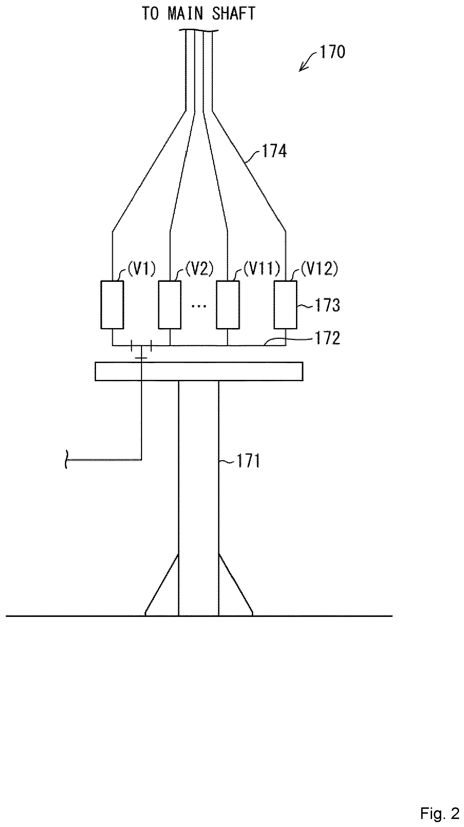

The following will discuss Example 1, with reference to Figs. 1 to 4. Fig. 1 is a view schematically illustrating an arrangement of a cleaning device 100 in accordance with Example 1. Fig. 2 is a view schematically illustrating an arrangement of a supply unit 170 of the cleaning device 100.

### (Cleaning system)

A cleaning system 600 is a system configured to clean an inner wall surface 502 of a main body 501 of a bell jar 500. The cleaning system 600 includes a cleaning device 100, a high pressure pump 200, and a cleaning liquid tank 300, as illustrated in Fig. 1.

The cleaning liquid tank 300 is a tank in which a cleaning liquid containing abrasive particles is stored. The cleaning liquid tank 300 can be also used for collecting the cleaning liquid which has been used for cleaning the bell jar 500. The high pressure pump 200 is a pump for delivering the cleaning liquid under high pressure from the cleaning liquid tank 300 to the cleaning device 100.

### (Cleaning device)

The cleaning device 100 causes nozzles 112 and 122 to discharges the cleaning liquid, which contains the abrasive particles, at a discharge pressure which is less likely to cause erosion of the nozzles 112 and 122. Then, the cleaning liquid impinges on the inner wall surface 502 of the bell jar 500 for use in production of polycrystalline silicon, so that the inner wall surface 502 is cleaned. Further, the cleaning device 100 adjusts a distance between a surface to be cleaned (inner wall surface 502) and the nozzles 112 and 122 to a constant distance so as to ensure that the cleaning liquid impinges on the inner wall surface 502 of the bell jar 500 at an impingement pressure which allows for removal of dirt on the inner wall surface 502. This can make erosion of the nozzles 112 and 122 etc. less likely to occur while making no sacrifice of a cleaning ability. The following will discuss in detail the cleaning device 100.

The cleaning device 100 includes a first cleaning unit 110, a second cleaning unit 120, a main shaft 140, a driving section 160, and a supply unit 170, as illustrated in Fig. 1.

Note that the bell jar 500, which is to be cleaned by the cleaning device 100, is in the form of a capsule and has an upper part 503 which is curved and a body part 504 which is cylindrical. Hereinafter, the inner wall surface of the upper part 503 is referred to as an upper-part curved inner wall surface 503a, and the inner wall surface of the body part 504 is referred to as a cylindrical-body lateral inner wall surface 504a.

### (First cleaning unit 110)

The first cleaning unit 110 is configured to clean the upper-part curved inner wall surface 503a. The first cleaning unit 110 includes a nozzle frame 111, nozzles 112, a nozzle header 113, and a nozzle hose 114.

The nozzles 112 are fixed to the nozzle frame 111 so as to be located along at least half an arc which passes an apex 503b of the upper-part curved inner wall surface 503a. The nozzles 112 can be provided, for example, in one line along the arc. The nozzles 112 can be alternatively provided in two or more lines along two or more arcs which pass the apex 503b. It is only necessary to provide the nozzles 112 such that a total extent of cleaning, which is carried out by the nozzles 112, covers an extent of half the arc.

The nozzles 112 themselves do not rotate. Further, the nozzles 112 each have a jet orifice which is also fixed so as not to rotate. For example, the nozzles 112 are arranged such that one (1) nozzle set is composed of three nozzles 112 and such that 10 nozzle sets (10 series of three nozzles 112) are provided in the nozzle frame 111. The nozzles 112 each include an inserted part which is desirably made of a material whose degree of hardness is higher than that of tungsten carbide. The nozzles 112 erode more at a higher discharge pressure. In light of this, the nozzles 112 are caused to discharge the cleaning liquid at a discharge pressure at which erosion of the nozzles 112, due to the cleaning liquid, occurs by not more than 500 µm/hour.

The distance between the upper-part curved inner wall surface 503a and the nozzles 112 is adjusted to a constant distance so as to ensure that the cleaning liquid impinges on the upper-part curved inner wall surface 503a at an impingement pressure which allows for removal of dirt on the upper-part curved inner wall surface 503a. The impingement pressure can be set to not less than 10 MPa. Although a larger impingement pressure leads to a greater cleaning effect, it is necessary to take into account a decrease in thickness of a wall having the inner wall surface 502 (object to be cleaned). Note that, in a case where the impingement pressure is too small, cleaning becomes insufficient. Therefore, it is desirable for the impingement pressure to be not less than 10 MPa, although it depends on a kind of the abrasive particles.

It is necessary to adjust the distance between the upper-part curved inner wall surface 503a and the nozzles 112, in order to ensure an impingement pressure which allows for removal of dirt on the upper-part curved inner wall surface 503a, by causing the nozzles 112 to discharge the cleaning liquid at a discharge pressure at which erosion of the nozzles 112 occurs by not more than 500 µm/hour. Specifically, it is preferable that the distance, between the upper-part curved inner wall surface 503a and the nozzles 112, is approximately 100 mm to 300 mm, more preferably 150 mm to 250 mm. The cleaning ability becomes higher in a case where the distance is closer to 0 mm. However, in a case where the distance is set within the above-described range, it is possible to use wide-angle nozzles 112. This allows an area, which is cleaned by a single nozzle, to be wider. This causes a room to be secured between the main body 501 of the bell jar 500 and the cleaning device 100. This ultimately makes it possible to more easily attach and detach the bell jar 500 to and from the cleaning device 100. The discharge pressure and the distance can be adjusted manually or automatically.

The nozzle frame 111 is provided so as to extend in a height direction of the bell jar 500, and includes a plurality of members so as to provide a projection toward the upper part of the bell jar 500. Further, the nozzle frame 111 can be configured to be made of two sets of the plurality of members. Note that each of the two sets is formed by the plurality of members which are arranged in parallel to the height direction of the bell jar 500. In this case, the two sets of the plurality of members are connected to the main shaft 140 (described later), via a nozzle frame 121, such that the two sets are axisymmetric with respect to an axis of the bell jar 500 which axis passes through the apex 503b.

The nozzle frame 111 rotates (moves) in synchronization with rotation of the main shaft 140, in a state in which the nozzles 112 are put close to the upper-part curved inner wall surface 503a. The nozzle frame 111 here rotates such that the distance, between the upper-part curved inner wall surface 503a and the nozzles 112, stays constant. In other words, the nozzle frame 111 rotates in synchronization with rotation of the main shaft 140 which is rotated by the main shaft 160. The nozzle frame 111 can be, for example, a reciprocating rotation in which a forward rotation is followed by a backward rotation. Note that the nozzle frame 111 only rotates, and the nozzle frame 111 therefore never moves up and down.

The nozzle header 113 distributes, to each of the nozzles 112, the cleaning water which is supplied from the supply unit 170 (later described), through nozzle hoses 114 and 174.

The nozzle hose 114 is a flexible high-pressure hose. In Example 1, a flow path of the cleaning liquid (nozzle hose 114), which flow path extends from the main shaft 140 to each of the nozzles 112 and 122, is flexible as described above. This allows the flow path to avoid having a sharper curve, as compared with a flow path made of a fixed pipe. This consequently makes it possible to prevent a trouble due to erosion of the flow path of the cleaning liquid from the main shaft 140 to each of the nozzles 112 and 122. In addition, because the flow path of the cleaning liquid has flexibility, the distance between the wall surface and the nozzles 112 and 122 can be easily adjusted.

### (Second cleaning unit)

The second cleaning unit 120 is configured to clean the cylindrical-body lateral inner wall surface 504a. The second cleaning unit 120 includes the nozzle frame 121, nozzles 122, a nozzle header 123, and a nozzle hose 124.

The nozzles 122 are fixed to the nozzle frame 121 so as to be located along a height direction of the cylindrical-body lateral inner wall surface 504a. It is only necessary to provide the nozzles 122 at different positions, respectively, in the height direction of the bell jar 500 which is fixed. For example, the nozzles 122 can be provided in a line along the shape in the height direction of the cylindrical-body lateral inner wall surface 504a. The nozzles 122 are caused to discharge the cleaning liquid at a discharge pressure at which erosion of the nozzles 122, due to the cleaning liquid, occurs by not more than 500 µm/hour.

The distance between the cylindrical-body lateral inner wall surface 504a and the nozzles 122 is adjusted to a constant distance so as to ensure that the cleaning liquid impinges on the cylindrical-body lateral inner wall surface 504a at an impingement pressure which allows for removal of dirt on the cylindrical-body lateral inner wall surface 504a. As described above, it is desirable that the impingement pressure be not less than 10 MPa and that the distance be 150 mm to 250 mm. The discharge pressure and the distance can be adjusted manually or automatically.

The nozzle frame 121 is a member where four bar members are fixed to each other. The bar members extend in parallel to the height direction of the bell jar 500. The nozzle frame 121 is connected to the main shaft 140 (later described). The main shaft 140 is caused to rotate and move up and down by the drive section 160. Accordingly, the nozzle frame 121 moves (rotates and moves up and down) in synchronization with the above-described rotation and up-and-down movement of the main shaft 140. The nozzle frame 121 moves (rotates and moves up and down) in synchronization with the rotation and up-and-down movement of the main shaft 140, in a state in which the nozzles 122 are put close to the cylindrical-body lateral inner wall surface 504a. The nozzle frame 121 here moves such that the distance between the cylindrical-body lateral inner wall surface 504a and the nozzles 122 stays constant.

The nozzle header 123 is attached to the nozzle frame 121, and distributes, to each of the nozzles 122, the cleaning water which is supplied from the supply unit 170 (later described).

In Example 1, the nozzles 122 are not provided all along the cylindrical-body lateral inner wall surface 504a in the height direction of the cylindrical-body lateral inner wall surface 504a, but are provided partially along the cylindrical-body lateral inner wall surface 504a in the height direction. Accordingly, the second cleaning unit 120 cleans an entire area of the cylindrical-body lateral inner wall surface 504a, by causing the nozzle frame 121 to rotate and move up and down.

Note that in a case where the nozzle frame 121 is caused to move up and down, a distance, by which the nozzle frame 121 moves up and down, can be set to, for example, 500 mm. Further, the distance, by which the nozzle frame 121 moves up and down, can be shortened in a case where the nozzle frame 121 is provided with the nozzles 122 which are spaced apart from each other. In addition, the nozzle frame 121 can move up and down spirally at the same time as rotation of the nozzle frame 121. Alternatively, the nozzle frame 121 can simply move up and down after rotation of the nozzle frame 121. Such up-and-down movement of the nozzle frame 121 can be a descending movement starting from, for example, an upper-limit position of the nozzle frame 121 as an original position. In this case, the nozzle frame 121 descends at a speed which is determined depending on the number of rotations.

The nozzle hose 124 carries the cleaning water from the supply unit 170 (later described) to each of the nozzles 122. The nozzle hose 124 is desirably a flexible high-pressure hose.

In Example 1, in the flow path of the cleaning liquid, which extends from the supply unit 170 to a discharge orifice of each of the nozzles 112 and 122, a flow rate of the cleaning liquid is controlled such that erosion of an inner wall of the flow path of the cleaning liquid, due to the cleaning liquid, occurs by not more than 1 µm/hour. Specifically, the flow rate is preferably not more than 2.0 m/s. This makes it possible to prevent a trouble due to wearing of the flow path of the cleaning liquid. The above control can be carried out manually or automatically.

Further, in Example 1, the nozzles 112 and 122 are not 3D nozzles (that is, the nozzles 112 and 122 themselves do not rotate). The nozzles 112 are fixed to the nozzle frame 111, and the nozzles 122 are fixed to the nozzle frame 121. With use of the nozzles 112 and 122 whose jet orifices are fixed, the inner wall surface 502 is cleaned by causing the nozzle frames 111 and 121 to move. Since a 3D nozzle has a sliding section at a rotational joint, the 3D nozzle may erode due to the sliding section. In a case where a 3D nozzle is used, the 3D nozzle is eroded by not less than 2000 µm/hour. Further, the 3D nozzle may defectively rotate due to erosion of a gear mechanism section which causes the 3D nozzle to rotate. As a result, the inner wall surface 502 may never be cleaned with that 3D nozzle. In contrast, in Example 1, the sliding section is eliminated from the nozzles 112 and 122, and erosion of the nozzles 112 and 122 is prevented. This makes it possible to carry out cleaning with the cleaning liquid containing the abrasive particles.

### (Main shaft)

The main shaft 140 (rotating section) is connected to the nozzle frames 111 and 121, and caused to rotate and move up and down by the driving section 160 (later described). This causes respective cleaning positions of the nozzles 112 and 121 to move via the nozzle frames 111 and 121.

The main shaft 140 is a hollow shaft. The main shaft 140 contains therein a plurality of nozzle hoses 174 (nozzle hoses 114 and 124) each of which serves as the flow path of the cleaning liquid to each of the nozzles 112 and 122. The main shaft 140 includes a shaft cover (not illustrated). The shaft cover makes it possible to prevent the cleaning water from coming in contact with the surface of the main shaft 140 and also to prevent the cleaning liquid from flowing into the driving section 160 from the inside of the bell jar 500 during cleaning of the inner wall surface 502. Further, the shaft cover is separated into an upper part and a lower part. The upper part is formed so as to cover a portion of the lower part. The main shaft 140 is provided with a gland packing (not illustrated) between the upper part and the lower part. The gland packing prevents the cleaning liquid from flowing into the main shaft 140.

Further, the cleaning device 100 can include a drier nozzle, which sends hot air or the like into the bell jar 500 and dry the inside of the bell jar 500 after cleaning.

### (Driving section)

The driving section 160 (driving mechanism) is configured to generate rotational and up-and-down driving force and to cause the main shaft 140 to rotate and move up and down. Specifically, the following will discuss a case where the nozzles 112 and 122 are in both of a first state in which the nozzles 112 of the first cleaning unit 110 are put close to the upper-part curved inner wall surface 503a and a second state in which the nozzles 122 of the second cleaning unit 120 are put close to the cylindrical-body lateral inner wall surface 504a. In the above first and second states, the driving section 160 causes the first cleaning unit 110 and the second cleaning unit 120 to move relative to the bell jar 500.

The driving section 160 includes an elevating motor 161 (second driving section) and a rotating motor 162 (first driving section and second driving section). The driving section 160 is provided not inside the bell jar 500 (cleaning space) but outside the bell jar 500, that is, outside a cleaning atmosphere. This can prevent erosion of the driving section 160 due to the cleaning liquid.

The elevating motor 161 causes the main shaft 140 to move up and down via a speed reducer. The rotating motor 162 causes the main shaft 140 to rotate, by use of a speed reducer and a roller chain.

### (Supply unit)

The supply unit 170 is configured to supply, to each of the nozzles 121 and 122 via the nozzle headers 113 and 123, the cleaning water which has been delivered from the cleaning liquid tank 300 by the high pressure pump 200. The supply unit 170 includes a valve header support 171, a valve header 172, high pressure valves 173, and the nozzle hoses 174, as illustrated in Fig. 2.

The valve header support 171 is a horizontally rotatable support stand, and rotates in synchronization with rotation of the main shaft 140. On the valve header support 171, the valve header 172 is provided. To the valve header 172, the high pressure valves 173 are attached. The valve header 172 switches a high pressure valve 173 to another high pressure valve 173, so that the cleaning water is supplied to predetermined nozzles 121 and 122.

The nozzle hoses 174 (flow paths of cleaning liquid) are flexible. Since the nozzle hoses 174 are flexible, the nozzle hoses 174 can absorb rotation and up-and-down movement which occur between the main shaft 140 and the high pressure valves 173. This consequently eliminates the need for using a joint including a sliding section between the main shaft 140 and each of the high pressure valve 173. As a result, it becomes possible to prevent a trouble due to wearing of the flow paths of the cleaning liquid, which extend from the supply unit 170 to the main shaft 140.

### (Variation)

The second cleaning unit 120 can be arranged such that the nozzles 122 are provided in a ring form along a shape in a circumferential direction of the cylindrical-body lateral inner wall surface 504a. In such an arrangement, the nozzle frame 121 does not rotate but moves up and down such that the distance, between the cylindrical-body lateral inner wall surface 504a and the nozzles 122, becomes constant while the nozzles 122 are being put close to the cylindrical-body lateral inner wall surface 504a. Note that the elevating motor 161 (third driving section) causes the nozzle frame 121 to move up and down.

The nozzles 122 can be alternatively provided so as to be (i) along the shape in the height direction of the cylindrical-body lateral inner wall surface 504a and (ii) in the ring form along the shape in the circumferential direction of the cylindrical-body lateral inner wall surface 504a.

### (Method of cleaning)

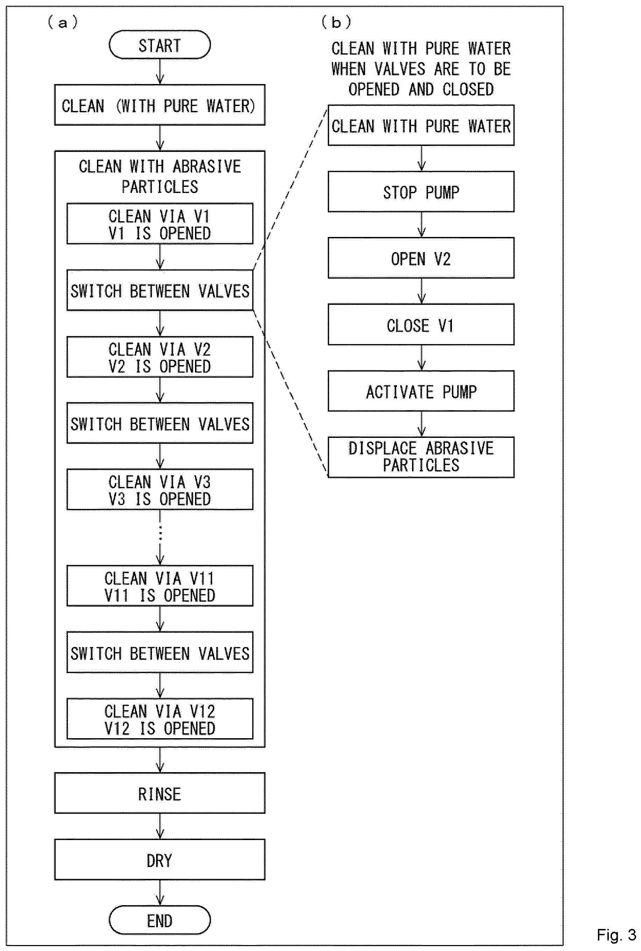

The following will discuss a method of cleaning in accordance with Example 1, with reference to Fig. 3. Fig. 3 is a flow chart depicting the method of cleaning by the cleaning device 100. Specifically, (a) of Fig. 3 is a flow chart depicting the method of cleaning, and (b) of Fig. 3 is a flow chart depicting switching of the high pressure valves 173.

First, as depicted in (a) of Fig. 3, the inside of the bell jar is washed with pure water. This is pre-cleaning. The pre-cleaning is followed by the start of cleaning with the cleaning liquid containing the abrasive particles. Specifically, such cleaning is carried out by (i) opening a predetermined first one (hereinafter, referred to as high pressure valve V1) of the high pressure valves 173 and then (ii) causing the main shaft 140 to rotate and move up and down by the driving section 160. After an area to be cleaned via the high pressure valve V1 has been completed, a second one of the high pressure valves 173 (hereinafter, referred to as high pressure valve V2) is opened and cleaning is carried out. After cleaning via each of all the high pressure valves 173 has been completed, rinsing is carried out with pure water. Subsequently, drying is carried out by the drier nozzle.

Further, as illustrated in (b) of Fig. 3, after the cleaning via the predetermined high pressure valve V1 has been completed, the high pressure valve V1 is cleaned with pure water so as to remove the abrasive particles remaining in the high pressure valve V1. Then, the high pressure pump 200 is stopped until (i) the high pressure valve V2 is opened and (ii) the high pressure valve V1 is closed after the above cleaning. Thereafter, an area to be cleaned is cleaned by the nozzles 112 and 122 which are connected to the high pressure valve V2.

With the above arrangement, after the high pressure pump 200 is stopped, the second high pressure valve V2 is opened before the high pressure valve V1 is closed. This makes it possible to prevent the path of cleaning from being completely closed. This allows pressure in the path of cleaning to be discharged. This ultimately allows for (i) prevention of a trouble due to opening and closing of valves during switching from a high pressure valve 173 to another high pressure valve 173 and (ii) prevention of erosion caused by an increased flow rate which results from the flow path narrowed in opening and closing the high pressure valves.

### Example 2

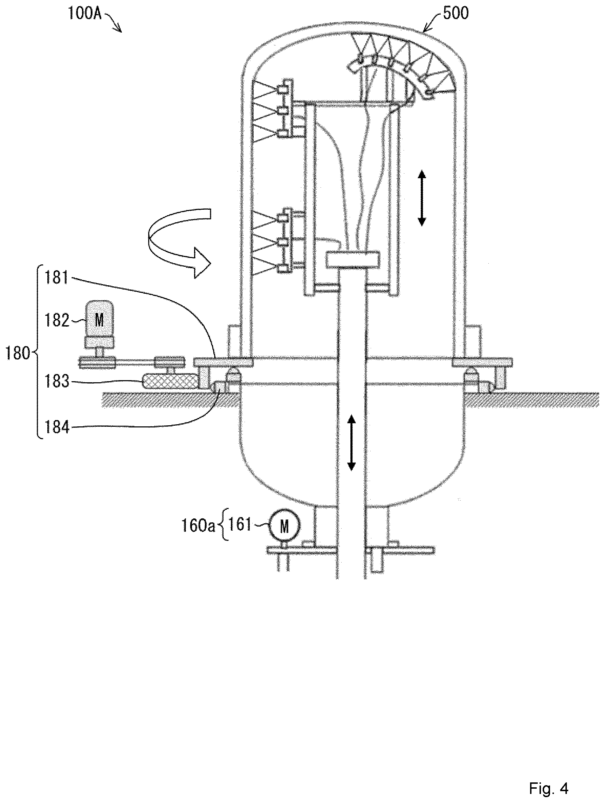

The following will discuss Example, with reference to Fig. 4. Fig. 4 is a view schematically illustrating an arrangement of a cleaning device 100A in accordance with Example 2. The cleaning device 100A is similar in arrangement to the cleaning device 100 except that the cleaning device 100A includes a driving section 160a in place of a driving section 160.

The driving section 160a is similar in arrangement to the driving section 160 except that the driving section 160a includes a bell jar driving section 180 and an elevating motor 161. The following will discuss a case where the nozzles 112 and 122 are in at least one of (i) a first state in which nozzles 112 of a first cleaning unit 110 is put close to an upper-part curved inner wall surface 503a and (ii) a second state in which nozzles 122 of a second cleaning unit 120 are put close to a cylindrical-body lateral inner wall surface 504a. The bell jar driving section 180 causes a bell jar 500 to move (rotate) in at least one of the above first and second states. The bell jar driving section 180 includes a rotary table 181, a bell jar rotating motor 182, a table driving tire 183, and a rotating bearing 184, as illustrated in Fig. 4. The bell jar driving section 180 is provided outside a cleaning atmosphere.

The rotary table 181 is provided on an installation surface in a horizontally rotatable manner. On the rotary table 181, the bell jar 500 is provided. The bell jar 500 rotates in synchronization with rotation of the rotary table 181. The rotating bearing 184 is provided between the rotary table 181 and the installation surface. The rotating bearing 184 allows the rotary table 181 to smoothly rotate.

The bell jar rotating motor 182 causes the table driving tire 183 to rotate via a speed reducer and a roller chain, and rotation of the bell jar rotating motor 182 is transferred to the rotary table 181 via rotation of the table driving tire 183. With this arrangement, the bell jar rotating motor 182 causes the bell jar 500 to rotate.

The driving section 160a (driving mechanism) includes the elevating motor 161 (second driving section). In other words, the first cleaning unit 110 and the second cleaning unit 120 do not rotate. Note however that when the second cleaning unit 120 carries out cleaning, the second cleaning unit 120 moves only up and down (double-headed arrow in Fig. 4).

In other words, in the cleaning device 100A, the bell jar 500 itself rotates (outline arrow in Fig. 4) and the second cleaning unit 120 moves up and down, so that the inner wall surface 502 is cleaned. This eliminates the need for a rotatable valve header 172 etc. which absorbs rotation of a supply unit as illustrated in Fig. 2. This arrangement is effective in a case where it is not possible to secure a space to be equipped with the above mechanism.

Note that it is also possible to arrange such that the inner wall surface 502 is cleaned by causing not the second cleaning unit 120 but the bell jar 500 to move up and down.

### (Sum-up of measures against erosion)

The following will sum up measures against erosion of the nozzles and erosion of the flow paths of the cleaning liquid in the above Examples. (1) The distance between the inner wall surface 502 and the nozzles 112 and 122 is adjusted, so that a sufficient impingement pressure, at which the cleaning liquid impinges on the inner wall surface 502, is ensured while respective discharge pressures of the nozzles 112 and 122 are suppressed. (2) The nozzles 112 and 122 and the flow paths of the cleaning liquid are provided with no sliding section. (3) The flow rate in the flow paths of the cleaning liquid is suppressed. (4) In the flow paths of the cleaning liquid, a sharp curve is avoided as much as possible. (5) The nozzles 112 and 122 each include an inserted part which is preferably made of a material whose degree of hardness is higher than that of tungsten carbide. (6) As a measure to prevent wearing of the high pressure valves 173, the abrasive particles remaining in pipes and valves are cleaned off by cleaning with pure water when the high pressure valves 173 are opened and closed. (7) As a measure to prevent wearing of the high pressure valves 173 and for prevention of a trouble caused by a sudden change in pressure due to opening and closing of the high pressure valves 173, the high pressure pump 200 is stopped when the high pressure valves 173 are opened and closed. (8) The whole of the driving section 160 is externally attached to the bell jar 500.

Further examples can also be expressed as follows:
An example is a method of cleaning an inner wall surface of a bell jar for use in production of polycrystalline silicon, by causing nozzles to discharge a cleaning liquid at the inner wall surface, the cleaning liquid containing abrasive particles, the method including the steps of: (a) causing the nozzles to discharge the cleaning liquid at a discharge pressure at which erosion of the nozzles, due to the cleaning liquid, occurs by not more than 500 µm/hour; and (b) adjusting a distance between the inner wall surface and the nozzles so that an impingement pressure, at which the cleaning liquid impinges on the inner wall surface, secures a pressure at which dirt on the inner wall surface can be removed.

In the above arrangement, the cleaning liquid contains abrasive particles. This increases a physical-removal ability of the cleaning liquid, so that a substance attached to the inner wall surface of the bell jar can be reliably removed.

Further, the distance between the inner wall surface and the nozzles is adjusted so that the impingement pressure, at which the cleaning liquid impinges on the inner wall surface, can be sufficient. Accordingly, even in a case where the cleaning liquid is discharged through the nozzles at a discharge pressure at which erosion of the nozzles occurs by not more than 500 µm/hour, it is possible to ensure a sufficient impingement pressure at which the cleaning liquid impinges on the inner wall surface, by placing the nozzles in the vicinity of the inner wall surface. Consequently, it is possible to prevent erosion of the nozzles for discharging the cleaning liquid and to reliably remove the substance attached to the inner wall surface of the bell jar at the same time.

Further, the method may preferably arranged such that: the impingement pressure is not less than 10 MPa.

The above arrangement makes it possible to have an impingement pressure at which the cleaning liquid containing abrasive particles can remove dirt on the inner wall surface.

Further, an exemplary method is preferably arranged to further includes the step of: (c) controlling a flow rate of the cleaning liquid in a flow path of the cleaning liquid up to a discharge orifice of each of the nozzles so that erosion of an inner wall of the flow path, due to the cleaning liquid, occurs by not more than 1 µm/hour.

The above arrangement makes it possible to also prevent erosion of the flow path of the cleaning liquid.

Further, in order to solve the above problems, a device in accordance with an example is a device for cleaning an inner wall surface of a bell jar for use in production of polycrystalline silicon, by causing nozzles to discharge a cleaning liquid at the inner wall surface, the cleaning liquid containing abrasive particles, the nozzles including first nozzles and second nozzles, the device comprising: a first cleaning unit including the first nozzles of the device, which are arranged along at least half an arc of an upper-part curved inner wall surface of the bell jar, the arc passing an apex of the upper-part curved inner wall surface; a second cleaning unit including the second nozzles of the device, which are arranged along a shape in a height direction of a cylindrical-body lateral inner wall surface of the bell jar; and a driving mechanism configured to cause the first cleaning unit and the second cleaning unit to move relative to the bell jar, in a state where the nozzles of the device are in both of (i) a first state in which the first nozzles of the first cleaning unit are put close to the upper-part curved inner wall surface and (ii) a second state in which the second nozzles of the second cleaning unit are put close to the cylindrical-body lateral inner wall surface.

In the above arrangement, the cleaning liquid contains abrasive particles. This increases a physical-removal ability of the cleaning liquid, so that a substance attached to the inner wall surface of the bell jar can be reliably removed.

Further, the driving mechanism causes the first cleaning unit and the second cleaning unit to move relative to the bell jar, in a state where the nozzles of the device are in both of (i) a first state in which first nozzles are put close to the upper-part curved inner wall surface and (ii) a second state in which second nozzles are put close to the cylindrical-body lateral inner wall surface. This makes it possible to clean all over the inner wall surface while the nozzles are kept close to the inner wall surface. Therefore, it is possible to ensure a sufficient impingement pressure at which the cleaning liquid impinges on the inner wall surface even in a case where the discharge pressure of the cleaning liquid is kept suppressed. Consequently, it is possible to prevent erosion of the nozzles for discharging the cleaning liquid and to reliably remove the substance attached to the inner wall surface of the bell jar at the same time.

Further, the device is preferably arranged such that: the driving mechanism includes: a first driving section configured to cause the first cleaning unit to move in the first state; and a second driving section configured to cause the second cleaning unit to move in the second state.

In the above arrangement, the first driving section and the second driving section can cause the first cleaning unit and the second cleaning unit to move relative to the bell jar, respectively.

Further, the device is preferably arranged such that: the second cleaning unit further includes third nozzles of the device, the third nozzles being arranged in a ring form along a shape in a circumferential direction of the cylindrical-body lateral inner wall surface of the bell jar; and the driving mechanism includes: a first driving section configured to cause the first cleaning unit to move, in the first state in which the first nozzles of the first cleaning unit are put close to the upper-part curved inner wall surface; and a third driving section configured to cause the second cleaning unit to move, in a third state in which the second nozzles and the third nozzles of the second cleaning unit are put close to the cylindrical-body lateral inner wall surface.

In the above arrangement, the second cleaning unit has nozzles which are arranged in a ring form along a shape in a circumferential direction of the cylindrical-body lateral inner wall surface. Further, the inner wall surface of the bell jar is cleaned by the following operations (1) and (2): (1) the first driving section causes the first cleaning unit to move in the bell jar, in the first state in which the first nozzles are put close to the inner wall surface; and (2) the third driving section causes the second cleaning unit to move in the bell jar, in a third state in which the second nozzles and the third nozzles of the second cleaning unit are put close to the inner wall surface. This makes it possible to clean all over the inner wall surface while the nozzles are kept close to the inner wall surface. Therefore, it is possible to ensure a sufficient impingement pressure at which the cleaning liquid impinges on the inner wall surface even in a case where the discharge pressure of the cleaning liquid is kept suppressed.

Further, the device is preferably arranged such that: the driving mechanism is provided outside a cleaning space.

In the above arrangement, the driving mechanism is provided outside the cleaning space. This makes it possible to prevent erosion of the driving section due to the cleaning liquid.

Further, the device is preferably arranged to further include: a flow path of the cleaning liquid which extends from a rotating section of the device to each of the nozzles, the flow path being flexible.

In the above arrangement, because of the above flexibility of the flow path of the cleaning liquid, it is possible to absorb rotation and up-and-down movement which occur between the cleaning space and the driving section. This consequently eliminates the need for using a joint including a sliding section for rotation and up-and-down movement. As a result, it becomes possible to prevent a trouble due to wearing of the flow path of the cleaning liquid which extends from the supply unit of the cleaning liquid to each of the nozzles.

Further, the device is preferably arranged such that: the driving mechanism includes a bell jar driving section configured to cause the bell jar to move, in at least one of (i) the first state in which the first nozzles of the first cleaning unit are put close to the upper-part curved inner wall surface and (ii) the second state in which the second nozzles of the second cleaning unit are put close to the cylindrical-body lateral inner wall surface.

In the above arrangement, the inner wall surface of the bell jar is cleaned by moving the bell jar, in at least one of the first state in which the first nozzles are put close to the inner wall surface and the second state in which the second nozzles are put close to the inner wall surface. This makes it possible to clean all over the inner wall surface while the nozzles are kept close to the inner wall surface. Therefore, it is possible to ensure a sufficient impingement pressure, at which the cleaning liquid impinges on the inner wall surface, even in a case where the discharge pressure of the cleaning liquid is kept suppressed.

### Reference Signs List

- 100: Cleaning device
- 110: First cleaning unit
- 120: Second cleaning unit
- 112: 122 Nozzle
- 114: Nozzle hose (flow path of cleaning liquid)
- 140: Main shaft (rotating section)
- 160: Driving section (driving mechanism)
- 161: Elevating motor (second driving section, third driving section)
- 162: Rotating motor (first driving section, second driving section)
- 174: Nozzle hose (flow path of cleaning liquid)
- 180: Bell jar driving section
- 500: Bell jar
- 502: Inner wall surface
- 503a: Upper-part curved inner wall surface
- 504a: Cylindrical-body lateral inner wall surface

## Claims

1. A device (100) for cleaning an inner wall surface (502) of a bell jar (500) for use in production of polycrystalline silicon, by causing nozzles (112; 122) to discharge a cleaning liquid at the inner wall surface (502), the cleaning liquid containing abrasive particles, the nozzles (112; 122) including first nozzles and second nozzles, the device comprising:
- a first cleaning unit (110) including the first nozzles of the device, which are arranged along at least half an arc of an upper-part curved inner wall surface (503a) of the bell jar (500), the arc passing an apex of the upper-part curved inner wall surface (503a), the upper-part curved inner wall surface (503a) being positioned up of a cylindrical-body lateral inner wall surface (504a) of the bell jar (500);
- a second cleaning unit (120) including the second nozzles of the device, which are arranged along the cylindrical-body lateral inner wall surface (504a) and along a height direction which is from a lower part to an upper part of the bell jar (500); and
- a driving mechanism (160) connected to the first cleaning unit (110) and the second cleaning unit (120) and configured to cause the first cleaning unit (110) and the second cleaning unit (120) to move relative to the bell jar (500), in a state where the nozzles (112; 122) of the device are in both of (i) a first state in which the first nozzles of the first cleaning unit (110) are put closer to the upper-part curved inner wall surface (503a) than is a center in the height direction of the bell jar (500) and (ii) a second state in which the second nozzles of the second cleaning unit (120) are put closer to the cylindrical-body lateral inner wall surface (504a) than is an axis of the bell jar (500) which axis passes through the apex.

2. The device (100) as set forth in claim 1, wherein the driving mechanism (160) includes:
- a first driving section configured to cause the first cleaning unit (110) to move in the first state in which the first nozzles of the first cleaning unit (110) are put closer to the upper-part curved inner wall surface (503a) than is the center in the height direction of the bell jar (500); and
- a second driving section configured to cause the second cleaning unit (120) to move in the second state in which the second nozzles of the second cleaning unit (120) are put closer to the cylindrical-body lateral inner wall surface (504a) than is the axis of the bell jar (500) which axis passes through the apex.

3. The device as set forth in claim 1, wherein the second cleaning unit (120) further includes third nozzles of the device, the third nozzles being arranged in a ring form along a circumferential direction of the cylindrical-body lateral inner wall surface (504a) of the bell jar (500); and the driving mechanism (160) includes:
- a first driving section configured to cause the first cleaning unit (110) to move, in the first state in which the first nozzles of the first cleaning (110) unit are put closer to the upper-part curved inner wall surface (503a) than is the center in the height direction of the bell jar; and
- a third driving section configured to cause the second cleaning unit (120) to move, in a third state in which the second nozzles and the third nozzles of the second cleaning unit (120) are put closer to the cylindrical-body lateral inner wall surface (504a) than is the axis of the bell jar (500) which axis passes through the apex.

4. The device as set forth in any one of claims 1 to 3, wherein the driving mechanism (160) is provided outside a cleaning space.

5. The device as set forth in any one of claims 1 to 4, further comprising a flexible flow path of the cleaning liquid which extends from a rotating section of the device to each of the nozzles, the flexible flow path being a nozzle hose.

6. The device as set forth in claim 1, wherein the driving mechanism includes a bell jar driving section configured to cause the bell jar (500) to move, in at least one of (i) the first state in which the first nozzles of the first cleaning unit (110) are put closer to the upper-part curved inner wall surface (503a) than is the center in the height direction of the bell jar (500) and (ii) the second state in which the second nozzles of the second cleaning unit (120) are put closer to the cylindrical-body lateral inner wall surface (504a) than is the axis of the bell jar (500) which axis passes through the apex.

## Patentansprüche

1. Vorrichtung (100) zum Reinigen einer Innenwandfläche (502) einer Glasglocke (500) zur Verwendung bei der Produktion von polykristallinem Silizium, indem Düsen (112; 122) dazu gebracht werden, eine Reinigungsflüssigkeit auf die Innenwandfläche (502) auszustoßen, wobei die Reinigungsflüssigkeit Schleifpartikel enthält, und wobei die Düsen (112; 122) erste Düsen und zweite Düsen aufweisen, wobei die Vorrichtung Folgendes aufweist:
- eine erste Reinigungseinheit (110), welche die ersten Düsen der Vorrichtung aufweist, welche mindestens entlang einer Hälfte eines Bogens einer gewölbten Innenwandfläche im oberen Teil (503a) der Glasglocke (500) angeordnet sind, wobei der Bogen durch einen Scheitelpunkt der gewölbten Innenwandfläche im oberen Teil (503a) verläuft und die gewölbte Innenwandfläche im oberen Teil (503a) oberhalb einer zylindrischen seitlichen Innenwandfläche des Körpers (504a) der Glasglocke (500) angeordnet ist;
- eine zweite Reinigungseinheit (120), welche die zweiten Düsen der Vorrichtung aufweist, welche entlang der zylindrischen seitlichen Innenwandfläche des Körpers (504a) und entlang einer Höhenrichtung, welche sich von einem unteren Teil zu einem oberen Teil der Glasglocke (500) erstreckt, angeordnet sind; und
- einen Antriebsmechanismus (160), welcher mit der ersten Reinigungseinheit (110) und der zweiten Reinigungseinheit (120) verbunden und dafür eingerichtet ist zu bewirken, dass sich die erste Reinigungseinheit (110) und die zweite Reinigungseinheit (120) relativ zur Glasglocke (500) in einem Zustand bewegen, in welchem die Düsen (112; 122) der Vorrichtung sowohl in (i) einem ersten Zustand, in welchem die ersten Düsen der ersten Reinigungseinheit (110) näher an der gewölbten Innenwandfläche des oberen Teils (503a) angeordnet sind als eine Mitte in der Höhenrichtung der Glasglocke (500), als auch (ii) in einem zweiten Zustand, in welchem die zweiten Düsen der zweiten Reinigungseinheit (120) näher an der zylindrischen seitlichen Innenwandfläche des Körpers (504a) angeordnet sind als eine Achse der Glasglocke (500), wobei die Achse durch den Scheitelpunkt verläuft.

2. Vorrichtung (100) nach Anspruch 1, wobei der Antriebsmechanismus (160) aufweist:
- einen ersten Antriebsabschnitt, welcher dafür eingerichtet ist, zu bewirken, dass sich die erste Reinigungseinheit (110) im ersten Zustand bewegt, in welchem die ersten Düsen der ersten Reinigungseinheit (110) näher an der gewölbten Innenwandfläche des oberen Teils (503a) angeordnet sind als die Mitte in der Höhenrichtung der Glasglocke (500); und
- einen zweiten Antriebsabschnitt, welcher dafür eingerichtet ist, zu bewirken, dass sich die zweite Reinigungseinheit (120) im zweiten Zustand bewegt, in welchem die zweiten Düsen der zweiten Reinigungseinheit (120) näher an der zylindrischen seitlichen Innenwandfläche des Körpers (504a) angeordnet sind als die Achse der Glasglocke (500), wobei die Achse durch den Scheitelpunkt verläuft.

3. Vorrichtung nach Anspruch 1, wobei die zweite Reinigungseinheit (120) ferner dritte Düsen der Vorrichtung aufweist, wobei die dritten Düsen in einer Ringform entlang einer Umfangsrichtung der zylindrischen seitlichen Innenwandfläche (504a) der Glasglocke (500) angeordnet sind; und wobei der Antriebsmechanismus (160) Folgendes aufweist:
- einen ersten Antriebsabschnitt, welcher dafür eingerichtet ist, zu bewirken, dass sich die erste Reinigungseinheit (110) im ersten Zustand bewegt, in welchem die ersten Düsen der ersten Reinigungseinheit (110) näher an der gewölbten Innenwandfläche des oberen Teils (503a) angeordnet sind als die Mitte in der Höhenrichtung der Glasglocke; und
- einen dritten Antriebsabschnitt, welcher dafür eingerichtet ist, zu bewirken, dass sich die zweite Reinigungseinheit (120) in einem dritten Zustand bewegt, in welchem die zweiten Düsen und die dritten Düsen der zweiten Reinigungseinheit (120) näher an der zylindrischen seitlichen Innenwandfläche des Körpers (504a) angeordnet sind als die Achse der Glasglocke (500), wobei die Achse durch den Scheitelpunkt verläuft, aufweist.

4. Vorrichtung nach einem der Ansprüche 1 bis 3, wobei der Antriebsmechanismus (160) außerhalb eines Reinigungsraums bereitgestellt ist.

5. Vorrichtung nach einem der Ansprüche 1 bis 4, ferner aufweisend einen flexiblen Strömungsweg der Reinigungsflüssigkeit, welcher sich von einem drehenden Abschnitt der Vorrichtung zu jeder der Düsen erstreckt, wobei der flexible Strömungsweg ein Düsenschlauch ist.

6. Vorrichtung nach Anspruch 1, wobei der Antriebsmechanismus einen Glasglockenantriebsabschnitt aufweist, welcher dafür eingerichtet ist, zu bewirken, das sich die Glasglocke (500) in mindestens einem der Zustände aus einer Gruppe umfassend (i) den ersten Zustand, in welchem die ersten Düsen der ersten Reinigungseinheit (110) näher an der gewölbten Innenwandfläche des oberen Teils (503a) angeordnet sind als die Mitte in der Höhenrichtung der Glasglocke (500) und (ii) den zweiten Zustand, in welchem die zweiten Düsen der zweiten Reinigungseinheit (120) näher an der zylindrischen seitlichen Innenwandfläche des Körpers (504a) angeordnet sind als die Achse der Glasglocke (500), wobei die Achse durch den Scheitelpunkt verläuft, bewegt.

## Revendications

1. Dispositif (100) pour nettoyer une surface de paroi intérieure (502) d'une cloche (500) utilisée dans la production de silicium polycristallin, en faisant en sorte que des buses (112 ; 122) déchargent un liquide de nettoyage sur la surface de paroi intérieure (502), le liquide de nettoyage contenant des particules abrasives, les buses (112 ; 122) comprenant des premières buses et des secondes buses, le dispositif comprenant :
- une première unité de nettoyage (110) comprenant les premières buses du dispositif, qui sont disposées le long d'au moins la moitié d'un arc d'une surface de paroi intérieure incurvée de partie supérieure (503a) de la cloche (500), l'arc passant par un sommet de la surface de paroi intérieure incurvée de partie supérieure (503a), la surface de paroi intérieure incurvée de partie supérieure (503a) étant positionnée vers le haut d'une surface de paroi intérieure latérale de corps cylindrique (504a) de la cloche (500) ;
- une deuxième unité de nettoyage (120) comprenant les deuxièmes buses du dispositif, qui sont disposées le long de la surface de paroi intérieure latérale du corps cylindrique (504a) et le long d'une le long d'une direction de hauteur qui va d'une partie inférieure à une partie supérieure de la cloche (500) ; et
- un mécanisme d'entraînement (160) relié à la première unité de nettoyage (110) et à la deuxième unité de nettoyage (120) et configuré pour faire bouger la première unité de nettoyage (110) et la deuxième unité de nettoyage (120) par rapport à la cloche (500), dans un état où les buses (112 ; 122) du dispositif sont à la fois dans (i) un premier état dans lequel les premières buses de la première unité de nettoyage (110) sont placées plus près de la surface de paroi intérieure incurvée de la partie supérieure (503a) que ne l'est un centre dans la direction de la hauteur de la cloche (500) et (ii) un second état dans lequel les secondes buses de la seconde unité de nettoyage (120) sont placées plus près de la surface de paroi intérieure latérale du corps cylindrique (504a) que ne l'est un axe de la cloche (500), qui passe par le sommet.

2. Dispositif (100) selon la revendication 1, dans lequel le mécanisme d'entraînement (160) comprend :
- une première section d'entraînement configurée pour amener la première unité de nettoyage (110) à se déplacer dans le premier état dans lequel les premières buses de la première unité de nettoyage (110) sont placées plus près de la surface de la paroi intérieure incurvée de la partie supérieure (503a) que ne l'est le centre dans la direction de la hauteur de la cloche (500) ; et
- une deuxième section d'entraînement configurée pour amener la deuxième unité de nettoyage (120) à se déplacer dans le deuxième état dans lequel les deuxièmes buses de la deuxième unité de nettoyage (120) sont placées plus près de la surface latérale de la paroi intérieure du corps cylindrique (504a) que ne l'est l'axe de la cloche (500) dont l'axe passe par le sommet.

3. Dispositif selon la revendication 1, dans lequel la deuxième unité de nettoyage (120) comprend en outre des troisièmes buses du dispositif, les troisièmes buses étant disposées en forme d'anneau le long d'une direction circonférentielle de la surface de paroi intérieure latérale (504a) du corps cylindrique de la cloche (500) ; et le mécanisme d'entraînement (160) comprend :
- une première section d'entraînement configurée pour faire bouger la première unité de nettoyage (110), dans le premier état dans lequel les premières buses de la première unité de nettoyage (110) sont placées plus près de la surface de paroi intérieure incurvée de la partie supérieure (503a) que ne l'est le centre dans la direction de la hauteur de la cloche ; et
- une troisième section d'entraînement configurée pour faire bouger la deuxième unité de nettoyage (120), dans un troisième état dans lequel les deuxièmes buses et les troisièmes buses de la deuxième unité de nettoyage (120) sont placées plus près de la surface de paroi intérieure latérale du corps cylindrique (504a) que l'axe de la cloche (500) qui passe par le sommet.

4. Dispositif tel que défini dans l'une quelconque des revendications 1 à 3, dans lequel le mécanisme d'entraînement (160) est prévu à l'extérieur d'un espace de nettoyage.

5. Dispositif tel que défini dans l'une quelconque des revendications 1 à 4, comprenant en outre une voie d'écoulement flexible du liquide de nettoyage qui s'étend d'une section rotative du dispositif à chacune des buses, la voie d'écoulement flexible étant un tuyau de buse.

6. Dispositif tel que décrit dans la revendication 1, dans lequel le mécanisme d'entraînement comprend une section d'entraînement de la cloche configurée pour faire bouger la cloche (500), dans au moins l'un des deux états parmi (i) le premier état dans lequel les premières buses de la première unité de nettoyage (110) sont placées plus près de la surface de paroi intérieure incurvée de la partie supérieure (503a) que ne l'est le centre dans la direction de la hauteur de la cloche (500) et (ii) le deuxième état dans lequel les deuxièmes buses de la deuxième unité de nettoyage (120) sont placées plus près de la surface de paroi intérieure latérale du corps cylindrique (504a) que ne l'est l'axe de la cloche (500) dont l'axe passe par le sommet.
